Europäisches Patentamt

European Patent Office

Office européen des brevets

(19)

(11) Publication number: **0 069 472**
**B1**

(12) **EUROPEAN PATENT SPECIFICATION**

(45) Date of publication of patent specification: **27.11.85**

(51) Int. Cl.⁴: **H 01 R 23/68**

(21) Application number: **82302965.7**

(22) Date of filing: **09.06.82**

(54) A low insertion force electrical socket assembly.

(30) Priority: **22.06.81 US 276423**

(43) Date of publication of application:
**12.01.83 Bulletin 83/02**

(45) Publication of the grant of the patent:
**27.11.85 Bulletin 85/48**

(84) Designated Contracting States:
**BE NL**

(56) References cited:
**DE-A-2 739 645**
**US-A-3 553 630**
**US-A-3 602 875**

(73) Proprietor: **AMP INCORPORATED**
**P.O. Box 3608 449 Eisenhower Boulevard**
**Harrisburg Pennsylvania 17105 (US)**

(72) Inventor: **MacDougall, Alan Robert**
**5077 Stacey Drive East, No. 204**
**Harrisburg Pennsylvania 17111 (US)**

(74) Representative: **Gray, Robin Oliver et al**
**BARON & WARREN 18 South End Kensington**
**London W8 5BU (GB)**

Courier Press, Leamington Spa, England.

## Description

A low insertion force electrical socket assembly is disclosed for electrical terminals, called leads, projecting from an electronic package. By way of example, an electronic package comprises miniature electrical circuit components interconnected by a metal lead frame. The lead frame has projecting multiple terminals, called leads. The circuit components and parts of the lead frame are imbedded in encapsulant to form an electrical package. The leads project from the encapsulant and provide connections for electrical inputs and outputs to the circuit components in the electrical package.

A socket assembly for an electronic package allows pluggable connection of the leads of the package with circuits of a printed circuit board. A typical socket assembly includes an insulation base carrying electrical receptacle contacts that are connected with respective circuits of a printed circuit board. The leads of the electronic package are pluggably inserted into the receptacle contacts and are readily withdrawn to remove the electronic package from the socket assembly. The receptacle contacts often are damaged when the leads of the package are inserted, especially if the leads are misaligned slightly with the receptacle contacts, and the misaligned leads are forced into the receptacle contacts.

There is known in U.S.A. 3,763,459 a low insertion force socket assembly into which misaligned leads are inserted without damaging the receptacle contacts of the socket. This advantage is achieved by having the receptacle contacts open during insertion of the misaligned leads. A reciprocating shutter mechanism is operated to close the receptacle contacts onto the leads and establish electrical connections therewith. The shutter mechanism also allows opening of the receptacle contacts to permit withdrawal of the leads. In this known socket the receptacle contacts must be received into respective apertures of the shutter mechanism. Assembly of the shutter mechanism apertures with the receptacle contacts is difficult especially if the socket is of miniature size. Another problem to overcome is the need for reducing the number and complexity of component parts required in the assembly.

US—A—4 080 032 discloses a low insertion force socket assembly having a base, contact receiving cavities in the base in parallel rows at a pair of opposite sides of the base, electrical contacts in the cavities each having a pair of opposed contact fingers for receiving therebetween an electrical terminal, a pair of elongate rails mounted on the base alongside respective rows of contacts and arranged to engage resilient fingers thereof, a cover overlying the rails and having cam surfaces facing and cooperating with cam follower surfaces on the rails, the cover being movable longitudinally relative to the rails and the base to effect camming engagement between the cam surfaces and the cam follower surfaces to displace the rails laterally and thereby deflect the resilient contact fingers laterally whereby the contacts may be placed in a condition in which the respective contact fingers are spaced apart to receive a terminal therebetween with low insertion force and a condition in which the respective contact fingers are urged together to clamp the terminal therebetween. In this arrangement the contacts are biased to a closed, terminal engaging position and are urged to an open, low insertion force condition by operation of the rails through the cam which is formed with inwardly facing cam surfaces engaging outwardly facing cam follower surfaces on the rails. Also the cover is secured in longitudinally slidable relation to the base and the rails by a superposed frame engaging the base.

It is an object of the invention to provide a low insertion force socket assembly of this general kind which is of simpler construction and assembly, using fewer and simpler parts and which is especially suited for sockets of miniature size.

Accordingly the invention is characterised in that the contacts have contact fingers which are normally spaced apart to a low insertion force condition, and the rails and cover are arranged by cam operation resiliently to displace the resilient fingers outwardly towards the respective other contact fingers to a terminal engaging condition, the cam surfaces being disposed between the rails and having outwardly facing sinuous cam profiles cooperating with inwardly facing sinuous follower profiles on the rails, the cover having connecting means engaging complementary means of the base to secure the cover and rails adapted to permit longitudinal movement of the cover relative to the base and the rails.

Suitably the connecting means on the cover comprises a resilient latch means latchingly engaging a complementary slot formed in the base and being elongate longitudinally to permit said longitudinal movement by sliding reciprocation of the latch means in the slot.

It is known from US—A—3 602 875 to provide a connector receptacle assembly in which a cover is releasably secured to a housing base by resilient latch arms on the cover latchingly engaging a complementary slot in the base.

Suitably the base includes a pair of detents spaced apart longitudinally and facing toward the cover, and the cover includes a resilient projecting finger arranged for detented engagement with each of the detents, alternately in turn, upon reciprocation of the cam together with the cover.

The present invention is further characterized in that, the cover and the cam are of one piece molded dielectric construction, the latch and the finger are cantilever beams joined integrally with the cover.

The present invention is further characterized in that the base and the rails and the cover have pilot holes therein which align with one another as an indicator of correct assembly of the base, the rails, and the cover.

A better understanding of the present invention

will be apparent by way of example from the following detailed description taken in conjunction with the drawings.

Figure 1 is an enlarged perspective view of a socket assembly with the parts exploded for the purposes of illustration;

Figure 2 is a plan view of the assembly with the parts assembled and a cover and a cam partially broken away and in section for the purpose of illustrating the cam in a first, detented position, and the receptacle contacts are shown as being open;

Figure 3 is a side elevation of the assembly as shown in Figure 2, and with the assembly shown in section taken along the line 3—3 of Figure 2;

Figure 4 is an enlarged plan view similar to Figure 2 and illustrating the cam in a second detented position, and the receptacle contacts closed;

Figure 5 is a view similar to Figure 3 with the assembly shown in section taken along the line 5—5 of Figure 4;

Figure 6 is an enlarged elevation view of the assembly shown in section taken along the line 6—6 of Figure 3; and

Figure 7 is a view similar to Figure 6 with the assembly shown in section taken along the line 7—7 of Figure 5.

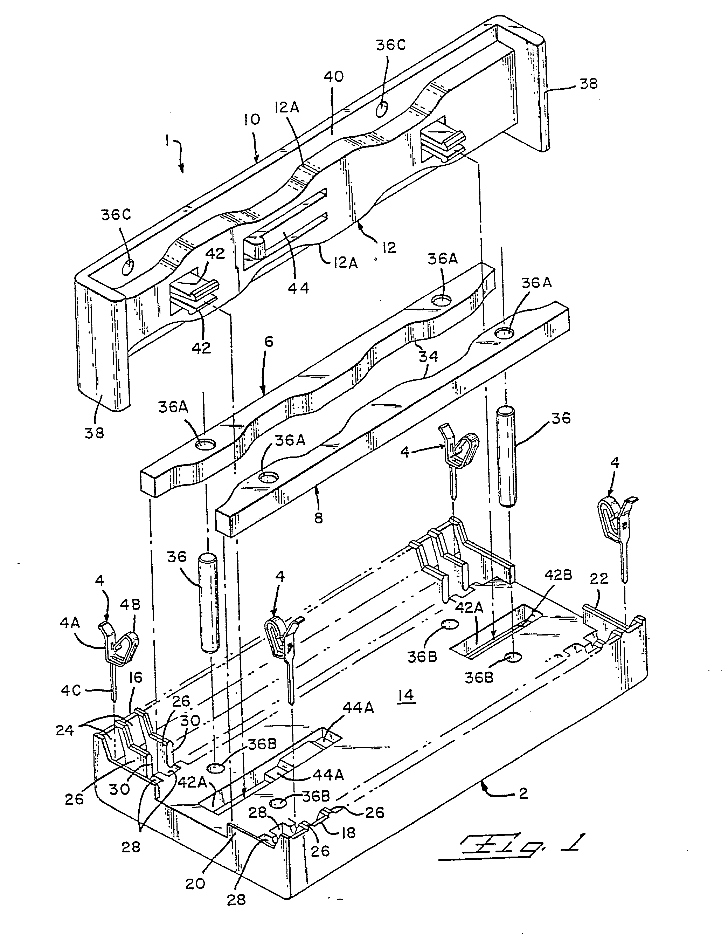

By way of example, Figure 1 shows a socket assembly 1, comprising a base 2, electrical receptacle contacts 4, a pair of rails 6, 8, and a cover 10 having a cam 12. The base 2 is of one piece molded plastic construction having a flat central table 14 encircled by projecting side walls 16, 18, and end walls 20, 22. Alongside the sidewall 16 is a row of open cavities 24 recessed into the base 2 and separated by partitions 26. The cavities project, at 28, past end walls 30 of the partitions 26 and partially into the table 14. Alongside the sidewall 18 is another row of open cavities 24 similar in all respects to the cavities 24 which are alongside the sidewall 16. Additional partitions 26 on the sidewall 18 separate the cavities 24.

Each contact 4 is stamped and formed in one piece from a blank of resilient, conductive metal, and comprises a first finger 4A and a second, resilient finger 4B which is doubled back on itself and projects toward the finger 4A. A projecting post type terminal 4C is partially severed out from the finger 4B and remains attached at one end to the finger 4B. The fingers 4A, 4B of each contact are opposed and are spaced apart from each other, and define an open electrical receptacle.

As shown in Figures 1, 2, 6 each contact 4 is mounted in a respective cavity 24. A finger 4A lies against a respective sidewall 16 or 18. Since the wall 16 or 18 is tapered, the finger 4A is flared and defines a funnel entry into the electrical receptacle defined by the opposed fingers 4A and 4B. The resilient finger 4B of each contact 4 projects· into the portion 28 of a respective cavity. Each finger 4B extends past the end walls 30 of the partitions 26 and projects partially into the table 14. The terminal 4C of each contact projects through a respective slot 32 in the bottom of each cavity 24 through the base 2.

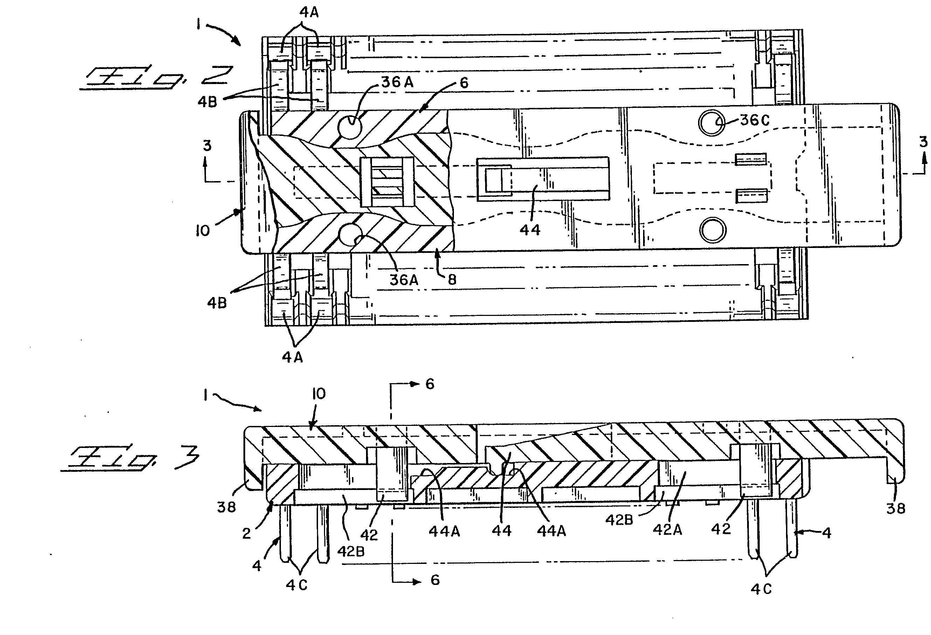

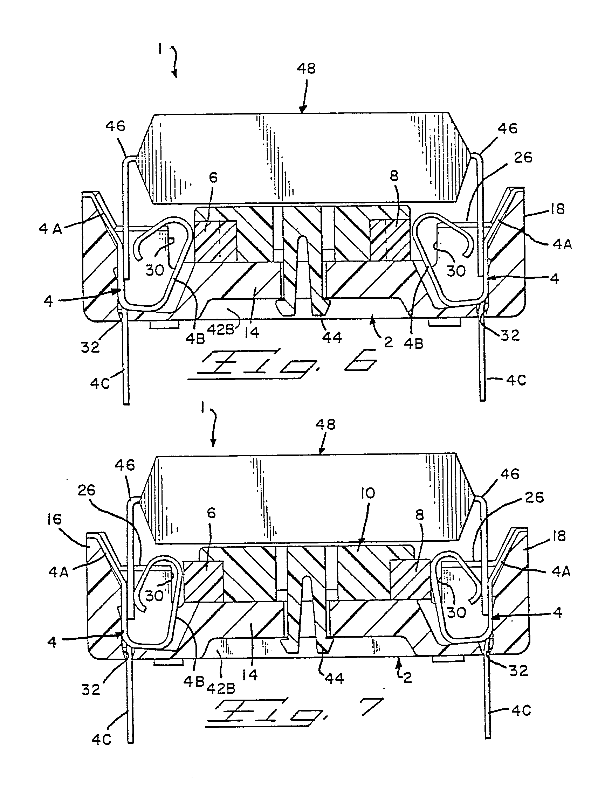

With reference to Figure 1, the rails 6, 8 are of elongated, molded plastic construction, each having a sinuous cam follower surface 34 and a pair of spaced apart pilot holes 36A. Figures 2 and 6 show the rails 6, 8 mounted on the table 14 alongside respective resilient fingers 4B of the contacts 4. Figure 1 shows the table 14 of the base 2 having pilot holes 36B. The pilot holes 36B may have removable alignment pins 36 which align with the pilot holes 36A of the rails 6, 8 during assembly with the base 2.

With reference to Figure 1, the cover 10 and cam 12 are of unitary, one piece, molded plastic construction. The cover includes end walls 38 which project out from a plate portion 40 in which are provided pilot holes 36C. The cam 12 projects out from the plate portion 40 and is provided with sinuous edges 12A on opposite elongated sides of the cam 12. The cover 10 also includes resilient L-shaped latches 42 and a resilient, L-shaped detent finger 44 projecting through and beyond the cam 12. The table 14 has a pair of slots 42A communicating with recesses 42B under the table 14, and a pair of recessed detents 44A to receive the detent finger 44.

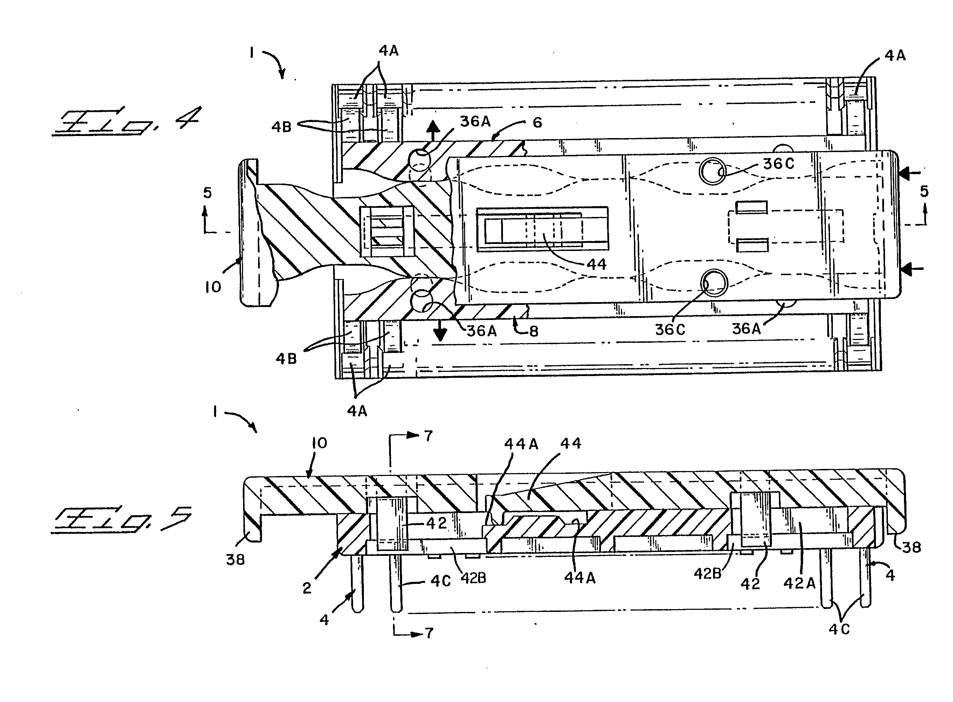

Figures 2 and 6 show the assembly of the cover 10 and cam 12 on the base 2. The pilot holes 36C of the cover are aligned with the alignment pins 36, and the cover is urged toward the table 14 until the L-shaped latches 42 pass through the slots 42A and hook in recesses 42B under the table 14. The cam 12 is then interposed between the rails 6, 8 with the edges 12A facing and nesting with the follower surfaces 34. Figure 3 shows the detent finger 44 in detented registration with a first detent 44A. Following assembly, the pilot pins 36 are removed, since they are not needed.

The assembly 1 as shown in Figures 2, 3, and 6 provides a low insertion force socket for electrical terminals in the form of leads 46 of a known electronic package 48. The leads 46 are readily inserted, without undue force, into the open receptacles defined by the opposed fingers 4A, 4B of the contacts 4. Figures 4, 5, and 7 show the cam 12 together with the cover 10 reciprocated to a second position, with the detent finger 44 transferred from detented registration in a first 44A to a second detent 44A. As the cam is reciprocated the latches 42 slide in and along the slots 42A. In addition, the sinuous edges 12A of the cam 12 slidably traverse against the sinuous follower surfaces 34 of the rails 6, 8, and the rails engage and deflect the resilient fingers 4B of the contacts 4 toward the opposed fingers 4A. Thereby the fingers 4A, 4B engage opposite sides of respective leads 46 to establish electrical connections therewith. Resilient spring energy becomes stored by the resilient fingers 4B during deflection thereof. The cam 12 together with the cover 10 is reciprocated to the first position shown in Figures 2, 3, and 6, allowing the receptacles to open by return resilient deflection of the fingers 4B, due to the stored energy. The stored energy is sufficient to cause the fingers 4B to push against the rails, and return the rails 6, 8 to their positions shown in Figures 2, 3, and 6.

## Claims

1. A low insertion force socket assembly (1) having a base (2), contact receiving cavities (24) in the base (2) in parallel rows at a pair of opposite sides of the base (2), electrical contacts (4) in the cavities (24) each having a pair of opposed contact fingers (4A, 4B) for receiving therebetween an electrical terminal (46), pair of elongate rails (6, 8) mounted on the base (2) alongside respective rows of contacts (4) and arranged to engage resilient fingers (4B) thereof, a cover (10) overlying the rails (6, 8) and having cam surfaces (12A) facing and cooperating with cam follower surfaces (34) on the rails (6, 8), the cover (10) being movable longitudinally relative to the rails (6, 8) and the base (2) to effect camming engagement between the cam surfaces (12A) and the cam follower surfaces (34) to displace the rails (6, 8) laterally and thereby deflect the resilient contact fingers (4B) laterally whereby the contacts (4) may be placed in a condition in which the respective contact fingers (4A, 4B) are spaced apart to receive a terminal (46) therebetween with low insertion force and a condition in which the respective contact fingers (4A, 4B) are urged together to clamp the terminal (46) therebetween, characterised in that the contacts (4) have contact fingers (4A, 4B) which are normally spaced apart to a low insertion force condition, and the rails (6, 8) and cover (10) are arranged by cam operation resiliently to displace the resilient fingers (4B) outwardly towards respective other contact fingers (4A) to a terminal (46) engaging condition, the cam surfaces (12A) being disposed between the rails (6, 8) and having outwardly facing sinuous cam profiles cooperating with inwardly facing sinuous follower profiles (34) on the rails (6, 8), the cover (10) having connecting means (42) engaging complementary means (42A) of the base (2) to secure the cover (10) and rails (6, 8) adapted to permit longitudinal movement of the cover (10) relative to the base (2) and the rails (6, 8).

2. A socket (1) as claimed in claim 1, characterised in that the connecting means (42) on the cover (10) comprises a resilient latch means (42) latchingly engaging a complementary slot (42A) formed in the base (2) and being elongate longitudinally to permit said longitudinal movement by sliding reciprocation of the latch means (42) in the slot (42A).

3. The socket (1) according to claim 1 or claim 2, characterized in that, the base (2) includes a pair of detents (44A) spaced apart longitudinally and facing toward the cover (10), and the cover (10) includes a resilient projecting finger (44) arranged for detented engagement with each of the detents (44A), alternately in turn, upon reciprocation of the cam (12) together with the cover (10).

4. The socket (1) according to claim 3, further characterized in that, the cover (10) and the cam (12) are of one piece molded dielectric construction, the latch (42) and the finger (44) are cantilever beams joined integrally with the cover (10).

5. The socket according to claims 1, 2 or 3 further characterized in that, the base (2) and the rails (6, 8) and the cover (10) have pilot holes (36B, 36A, 36C) therein which align with one another as an indicator of correct assembly of the base (2), the rails (6, 8), and the cover (10).

## Patentansprüche

1. Leichtgängige Steckdosenanordnung (1) mit einer Grundplatte (2), mit in der Grundplatte (2) vorgesehenen, zur Aufnahme von Kontakten bestimmten Hohlräumen (24) in parallelen Reihen an zwei einander gegenüberliegenden Seiten der Grundplatte (2), wobei in den Hohlräumen (24) elektrische Kontakte (4) angeordnet sind, die jeweils zwei einander gegenüberliegende Kontaktfinger (4A, 4B) besitzen, zwischen die eine elektrische Anschlußklemme (46) einführbar ist, mit zwei langgestreckten Schienen (6, 8), die auf der Grundplatte (2) längs zugeordneter Reihen von Kontakten (4) angebracht und so angeordnet sind, daß sie auf deren federnde Finger (4B) einwirken, mit einem Deckel (10), der auf den Schienen (6, 8) liegt und Nockenflächen (12A) bestizt, welche Nockengegenflächen (34) an den Schienen (6, 8) gegenüberstehen und mit ihnen zusammenwirken, wobei der Deckel (10) in Längsrichtung gegenüber den Schienen (6, 8) und der Grundplatte (2) bewegbar ist, um die Nockenflächen (12A) und die Nockengegenflächen (34) in Wechselwirkung miteinander treten zu lassen, damit die Schienen (6, 8) seitwärts verschoben und dadurch die federnden Kontaktfinger (4B) seitwärts ausgelenkt werden, wodurch die Kontakte (4) in eine Lage bringbar sind, in der die einander zugeordneten Kontaktfinger (4A, 4B) Abstand voneinander haben, um zwischen ihnen eine Anschlußklemme (46) mit geringer Einsteckkraft aufzunehmen und in eine Lage, in der die zugehörigen Kontaktfinger (4A, 4B) aufeinander gedrückt sind, so daß die Anschlußklemme (46) zwischen ihnen eingeklemmt ist, dadurch gekennzeichnet, daß die Kontakte (4) mit Kontaktfingern (4A, 4B) versehen sind, die normalerweise in einer voneinander distanzierten Stellung mit niederer Einschubkraft sind und daß die Schienen (6, 8) und der Deckel (10) durch die Nockenwirkung federnd angeordnet sind und die federnden Finger (4B) in der Weise auswärts gegen zugeordnete andere Kontaktfinger (4A) in eine eine Anschlußklemme (46) habende Stellung verbringbar sind und daß die Nockenflächen (12A) sich zwischen den Schienen (6, 8) befinden und auswärts weisende sinusförmige Nockenprofile besitzen, die mit an den Schienen (6, 8) angeordneten, einwärts weisenden sinusförmigen Nockengegenprofilen (34) zusammenwirken, und daß der Deckel (10) eine Verbindungseinrichtung (42) aufweist, die mit einer komplementären Einrichtung (42A) der Grundplatte (2) zusammen-

wirkt, um den Deckel (10) und die Schienen (6, 8) zu halten und eine Längsbewegung des Deckels (10) gegenüber der Grundplatte (2) und den Schienen (6, 8) zu ermöglichen.

2. Steckdose (1) nach Anspruch 1, dadurch gekennzeichnet, daß die Verbindungseinrichtung (42) an dem Deckel (10) ein federndes Rastelement (42) umfaßt, das rastend in einen komplementär geformten Schlitz (42A) eingreift, der in der Grundplatte (2) ausgebildet ist und in Längsrichtung verläuft, damit die Längsbewegung durch Hin- un Hergleiten des Rastelements (42) in dem Schlitz (42A) ermöglicht ist.

3. Steckdose (1) nach Anspruch 1 oder 2, dadurch gekennzeichnet, daß die Grundplatte (2) zwei in Längsrichtung voneinander entfernte Sperren (44A) aufweist, die zum Deckel (10) hin zeigen, und daß der Deckel (10) einen federnden vorspringenden Finger (44) aufweist, der beim Hin- und Herbewegen des Nockens (12) gemeinsam mit dem Deckel (10) abwechselnd der Reihe nach in jede der beiden Sperren (44A) einzurasten vermag.

4. Steckdose (1) nach Anspruch 3, dadurch gekennzeichnet, daß der Deckel (10) und der Nocken (12) einstückig aus dielektrischem Material geformt sind, und daß das Rastelement (42) und der Finger (44) vorspringende Arme darstellen, die einstückig mit dem Deckel (10) ausgebildet sind.

5. Steckdose nach Anspruch 1, 2 oder 3, dadurch gekennzeichnet, daß in der Grundplatte (2), den Schienen (6, 8) und dem Deckel (10) Führungsöffnungen (36B, 36A, 36C) vorgesehen sind, die miteinander fluchten zum Zeichen für den einwandfreien Zusammenbau von Grundplatte (2), Schienen (6, 8) und Deckel (10).

**Revendications**

1. Ensemble de douilles (1) à force d'insertion basse comportant une base (2), des cavités (24) destinées à recevoir des contacts dans la base (2), disposées en des rangées parallèles au niveau de deux côtés opposés de la base (2), des contacts électriques (4) dans les cavités (24) comportant chacun deux doigts de contact opposés (4A, 4B) destinés à recevoir entre eux une borne électrique (46), deux longues barres (6, 8) montées sur la base (2) le long des rangées de contacts (4) respectives et propres à attaquer des doigts élastiques (4B) de ces contacts, un couvercle (10) recouvrant les barres (6, 8) et comportant des surfaces de came (12A) juxtaposées contre des surfaces suiveuses de came (34) des barres (6, 8) et coopérant avec celles-ci, le couvercle (10) pouvant être déplacé longitudinalement par rapport aux barres (6, 8) et à la base (2) pour effectuer un engagement à effet de came entre les surfaces de came (12A) et les surfaces suiveuses de came (34) en vue de déplacer les barres (6, 8) latéralement et ainsi de faire fléchir les doigts de contact élastiques (4B) latéralement, de sorte que les contacts (4) peuvent être amenés dans un état dans lequel les doigts de contact (4A, 4B) respectifs sont espacés l'un de l'autre pour recevoir une borne (46) entre eux avec une force d'insertion basse et un état dans lequel les doigts de contact (4A, 4B) respectifs sont sollicités l'un vers l'autre pour serrer la borne (46) entre eux, caractérisé en ce que les contacts (4) comportent des doigts de contact (4A, 4B) qui sont normalement espacés dans un état à force d'insertion basse et les barres (6, 8) ainsi que le couvercle (10) sont agencés pour déplacer élastiquement par effet de came, les doigts élastiques (4B) vers l'extérieur vers les autres doigts de contact (4A) respectifs dans un état d'engagement de bornes (46), les surfaces de came (12A) étant disposées entre les barres (6, 8) et comportant des profils de came sinueux tournés vers l'extérieur coopérant avec des profils suiveurs de came sinueux (34) tournés vers l'intérieur sur les barres (6, 8), le couvercle (10) comportant des moyens de jonction (42) venant en prise avec des moyens complémentaires (42A) de la base (2) pour fixer le couvercle (10) et les barres (6, 8), tout en permettant un déplacement longitudinal du couvercle (10) par rapport à la base (2) et aux barres (6, 8).

2. Ensemble de douilles (1) suivant la revendication 1, caractérisé en ce que les moyens de jonction (42) sur le couvercle (10) comprennent un élément de verrouillage élastique (42) qui s'engage à des fins de verrouillage avec une fenêtre complémentaire (42A) formée dans la base (2) et oblongue dans le sens longitudinal pour permettre le déplacement longitudinal par un mouvement de coulissement en va-et-vient de l'élément de verrouillage (42) dans la fenêtre (42A).

3. Ensemble de douilles (1) suivant la revendication 1 ou 2, caractérisé en ce que la base (2) comprend deux arrêts (44A) espacés longitudinalement l'un de l'autre et tournés vers le couvercle (10), et le couvercle (10) comprend un doigt saillant élastique (44) propre à venir en prise avec un effet de déclic avec chacun des arrêts (44A), tour à tour en alternance, lorsque la came (12) est déplacée dans un sens et dans l'autre avec le couvercle (10).

4. Ensemble de douilles (1), suivant la revendication 3, caractérisé en outre en ce que le couvercle (10) et la came (12) sont faits d'une seule pièce en matière diélectrique moulée, l'élément de verrouillage (42) et le doigt (44) étant des éléments en porte à faux faisant partie intégrante du couvercle (10).

5. Ensemble de douilles suivant la revendication 1, 2 ou 3, caractérisé en outre en ce que la base (2) et les barres (6, 8) ainsi que le couvercle (10) comportent des trous de guidage (36B, 36A, 36C) qui viennent en ligne les uns avec les autres et qui indiquent l'assemblage correct de la base (2), des barres (6, 8) et du couvercle (10).

_Fig. 1_

Fig. 2

Fig. 3

0 069 472

_Fig. 4_

_Fig. 5_

_Fig. 6_

_Fig. 7_